# EUROPÄISCHE PATENTSCHRIFT

(11) **EP 2 085 993 B1**
(45) Veröffentlichungstag und Bekanntmachung des Hinweises auf die Patenterteilung: **26.06.2013**
(21) Anmeldenummer: 08002680.0
(22) Anmeldetag: 13.02.2008
(51) Int. Cl.: H01H 13/02

(54) **Sensor und Verfahren zu dessen Herstellung**
Sensor and method for its production
Capteur et procédé destiné à sa fabrication

(30) Priorität: 30.01.2008 DE 102008006746
(43) Veröffentlichungstag der Anmeldung: 05.08.2009
(73) Patentinhaber: Pepperl + Fuchs GmbH, 68307 Mannheim (DE)
(72) Erfinder: Schoen, Dierk Dr., 68307 Mannheim (DE)
(74) Vertreter: Schiffer, Axel Martin

(56) Entgegenhaltungen:
- EP-A- 0 417 048
- EP-A- 1 806 564
- DE-A1- 10 359 885

## Beschreibung

Die vorliegende Erfindung betrifft in einem ersten Gesichtspunkt einen Näherungsschalter nach dem Oberbegriff des Anspruchs 1.

In einem zweiten Gesichtspunkt bezieht sich die Erfindung auf ein Verfahren zur Herstellung eines Näherungsschalters.

Ein gattungsgemäßer Näherungsschalter ist beispielsweise in DE 103 43 529 A1 beschrieben und weist folgende Komponenten auf: Eine Wandlereinheit, die in einer Gehäusehülse an einem Messende angeordnet ist, Anschlussmittel an einem dem Messende gegenüberliegenden Anschlussende der Gehäusehülse, einen in der Gehäusehülse aufgenommenen Baugruppenträger, auf dem eine Sensorelektronik angeordnet ist und der sich entlang einer Achse der Gehäusehülse erstreckt und Leuchtmittel zum optischen Signalisieren von Betriebs- und/oder Schaltzuständen des Näherungsschalter nach außen.

Solche Sensoren werden beispielsweise in der Automatisierungstechnik für eine große Vielzahl von Aufgaben eingesetzt.

Um für Bedienpersonal eine Information über einen Betriebs- oder Schaltzustand des Sensors bereitzustellen, werden bei bekannten Sensoren die gewünschten Informationen optisch nach außen signalisiert. Eine grundlegende Aufgabenstellung ist hierbei, das Licht der verwendeten Leuchtmittel so nach außen zu führen, dass eine möglichst gute Rundumsichtbarkeit erreicht wird. Die optischen Signale und die optische Information sollen also möglichst weitgehend unabhängig vom Standort des Betrachters gut wahrnehmbar sein.

Beschränkungen ergeben sich dabei insoweit, als einerseits ein Durchmesser eines beispielsweise zylindrischen Sensors so klein wie möglich gewählt werden soll. Andererseits soll aber dennoch eine möglichst große und möglichst gut ausgeleuchtete Fläche, beispielsweise an einer Stirnseite, des Sensors bereitgestellt werden.

Bei bisherigen Lösungen sind die Leuchtmittel auf demselben Baugruppenträger wie die Sensorelektronik positioniert. Dies führt dazu, dass mindestens Teilbereiche einer Leuchtfläche nicht gut ausgeleuchtet werden.

In EP 0 417 048 A2 ist eine elektrische Schaltvorrichtung beschrieben, bei der ein Schaltzustand mit Hilfe von Leuchtmitteln nach außen signalisiert wird. Dieses Dokument bezieht sich im Wesentlichen auf mechanische Verbesserungen solcher Schaltvorrichtungen. Eine Signalisierung des Schaltzustands auf beiden Seiten einer Einbauwand ist dort nicht möglich.

In EP 1 806 564 A2 ist ein Gehäuse für einen Näherungsschalter beschrieben, bei welchem an einer Anschlussseite einer Gehäusehülse eine Signalisierung eines Schaltzustands des Näherungsschalters erfolgen kann. Hierzu wird ein spezieller Gehäuseabschluss eingesetzt. Eine Signalisierung auf beiden Seiten einer Einbauwand ist auch dort nicht möglich.

Eine **Aufgabe** der Erfindung ist es, einen Näherungsschalter zu schaffen, bei dem das zur Verfügung stehende Licht der Leuchtmittel besonders effektiv zur Signalisierung von Betriebs- und/oder Schaltzuständen eingesetzt werden kann. Außerdem soll ein Verfahren zur Herstellung eines solchen Näherungsschalters angegeben werden.

Diese Aufgabe wird in einem ersten Aspekt durch den Näherungsschalter mit den Merkmalen des Anspruchs 1 gelöst.

In verfahrensmäßiger Hinsicht wird diese Aufgabe durch das Verfahren mit den Merkmalen des Anspruchs 15 gelöst.

Bevorzugte Ausgestaltungen des erfindungsgemäßen Näherungsschalters und vorteilhafte Varianten des erfindungsgemäßen Verfahrens sind Gegenstand der abhängigen Ansprüche und werden außerdem in der folgenden Beschreibung, insbesondere im Zusammenhang mit den Figuren, erläutert.

Der Näherungsschalter der oben genannten Art ist erfindungsgemäß dadurch weitergebildet, dass ein separater plattenartiger Leuchtmittelträger vorhanden ist, dass eine Mehrzahl von Leuchtmitteln auf dem Leuchtmittelträger angeordnet ist und dass der Leuchtmittelträger im Bereich der Wandlereinheit querstehend zum Baugruppenträger angeordnet ist.

Bei dem erfindungsgemäßen Verfahren werden folgende Verfahrensschritte durchgeführt: Ein Schirmbecher wird mit einer Wandleraufnahme verbunden, ein Wandlerelement wird in den Schirmbecher eingesetzt, wobei der Schirmbecher, die Wandleraufnahme und das Wandlerelement eine Wandlereinheit bilden, ein plattenartiger Leuchtmittelträger, auf dem eine Mehrzahl von Leuchtmitteln angeordnet ist, wird mit der Wandlereinheit verbunden, ein Baugruppenträger mit einer Sensorelektronik wird an einem Messende mit der Wandlereinheit verbunden, wobei der Leuchtmittelträger relativ zum Baugruppenträger im zusammengebauten Zustand querstehend angeordnet ist, und der Baugruppenträger wird mit der Wandlereinheit in eine Gehäusehülse eingesetzt, wobei im zusammengebauten Zustand eine Achse der Gehäusehülse quer zum Leuchtmittelträger verläuft.

Ein erster Kerngedanke der Erfindung kann darin gesehen werden, die Anordnung der Sensorelektronik von der Positionierung der Leuchtmittel zu entkoppeln. Hierdurch gewinnt man eine größere Freiheit bei der Anordnung der Leuchtmittel.

Als weiterer wesentlicher Kerngedanke der Erfindung kann erachtet werden, die Leuchtmittel auf einem separaten Leuchtmittelträger zu positionieren und diesen quer zu einer Gehäuseachse anzuordnen. Die Leuchtmittel können so beispielsweise unmittelbar hinter einer Stirnseite des Näherungsschalters, also direkt hinter einer auszuleuchtenden Signalleuchtfläche, positioniert werden.

Bei der Erfindung kann demgemäß mit einfachen Mitteln eine erheblich verbesserte Ausleuchtung einer Signalleuchtfläche erzielt werden.

Bei den Näherungsschaltern kann es sich grundsätzlich um jede Art von Sensoren zum Nachweis von Gegenständen oder Objekten handeln. Besonders vorteilhaft kann die vorliegende Erfindung für Sensoren im industriellen Bereich, beispielsweise induktive oder kapazitive Sensoren, Druck- oder Temperatursensoren oder auch optische Sensoren eingesetzt werden.

Der erfindungsgemäße Näherungsschalter wird im Folgenden auch kurz als Sensor bezeichnet.

Bei dem Wandlerelement kann es sich grundsätzlich um jedes Element handeln, welches zum Nachweis einer physikalischen Größe geeignet ist. Beispielsweise kann das Wandlerelement ein Piezo-Element eines Ultraschallsensors, eine Spule oder ein Schwingkreis eines induktiven Näherungsschalters, eine kapazitive Sonde, ein Thermoelement oder auch ein Fotodetektor eines optischen Sensors sein.

Die Achse der Gehäusehülse kann beispielsweise die Zylinderachse einer zylindrischen Gehäusehülse sein. Der Baugruppenträger, bei dem es sich insbesondere um eine konventionelle Leiterplatte handeln kann, erstreckt sich dann so innerhalb der Gehäusehülse, dass die Oberfläche des Baugruppenträgers im Wesentlichen parallel zur Achse der Gehäusehülse verläuft. Dabei muss die Achse nicht notwendig durch den Baugruppenträger verlaufen, sondern dieser kann auch beispielsweise gegenüber einer Zylinderachse geringfügig versetzt angeordnet sein.

An einem Anschlussende der Gehäusehülse werden die Anschlussmittel angebracht, wobei es sich beispielsweise um einen Steckerabgang oder auch um einen Kabelabgang handeln kann.

Bei einer bevorzugten Variante des erfindungsgemäßen Sensors ist die Wandleraufnahme wenigstens teilweise aus einem transparenten Kunststoff gebildet. Das Licht der Leuchtmittel kann dann durch die Wandleraufnahme nach außen geleitet werden. Eine wesentliche Kernidee dieser Weiterbildung beinhaltet, dass die Leuchtmittel im Bereich der Wandleraufnahme angeordnet werden, so dass die Wandleraufnahme ähnlich wie ein Lichtwellenleiter das Licht an einen vorderen Teil oder jedenfalls einen exponierten Teil des Sensors bringen kann. Im Stand der Technik war dies bisher aus Platzgründen kaum möglich. Hierdurch ergibt sich eine Reihe von weiteren Vorteilen.

Beispielsweise ermöglicht die Erfindung insgesamt eine um bis zu 50% kürzere Bauform von Ultraschallwandlern, so dass insgesamt deutlich kleinere Sensoren hergestellt werden können.

Die Wandleraufnahme kann bevorzugt durch Umspritzen des Schirmbechers hergestellt werden. Hierdurch ergeben sich verbesserte Eigenschaften bei Hochspannungstest sowie außerdem, aufgrund der verkürzten Bauform, Vereinfachungen beim Einspeisen eines Stroms. Schließlich können auch verbesserte EMV-Eigenschaften erzielt werden.

Das erfindungsgemäße Verfahren wird bevorzugt als modulares und standardisiertes Fertigungsverfahren ausgeführt, wodurch vor allem in der Endmontage der Sensoren Herstellkosten gespart werden können. Insbesondere können die Wandleraufnahme oder die Wandlereinheit modular gebildet sein.

Der, insbesondere plattenartige, Baugruppenträger mit der Sensorelektronik und dem Leuchtmittelträger mit den Leuchtmitteln kann als Elektronikmodul bezeichnet werden, der insbesondere von hinten, also von einer einer Messseite abgewandten Seite in die Wandleraufnahme eingesteckt oder eingeschoben wird. Hierdurch ergeben sich Vorteile bei der Endmontage und darüber hinaus kann eine Montage der Wandler insgesamt optimiert werden.

Bei zylindrischen Sensoren ragt die Wandleraufnahme bevorzugt bis zu einer Stirnseite des Sensors durch. Die aktive Sensorfläche eines Näherungsschalters oder Anwesenheitssensors kann beispielsweise von einem Leuchtmittel oder mehreren Leuchtmitteln zur Schaltzustandsanzeige oder zur Anzeige von Betriebszuständen umgeben sein. Alternativ oder ergänzend kann das Leuchtmittel oder können leuchtende Flächen auch in einem mittigen Bereich, insbesondere im Zentrum einer Sensorfläche, angeordnet werden.

Das Licht der Leuchtmittel kann dabei noch effektiver ausgenutzt werden, wenn an der Wandleraufnahme für jedes Leuchtmittel Lichteinkoppelelemente angeformt sind. Diese Lichteinkoppelelemente sind bevorzugt so geformt, dass möglichst viel Licht der Leuchtmittel in die wenigstens teilweise transparente Wandleraufnahme eingekoppelt wird. Im Übrigen ist die Wandleraufnahme zweckmäßig so gebildet, dass das Licht möglichst verlustfrei bis zu einer Leuchtfläche geleitet und dort wiederum möglichst effektiv ausgekoppelt wird. Hierzu können weitere Maßnahmen getroffen werden. Beispielsweise werden die Wandleraufnahmen, wobei es sich typischerweise um Spritzgussteile handelt, gezielt so gefertigt, dass an gewünschten Stellen innere Hohlräume, die auch als Lunker bezeichnet werden, gebildet werden.

Die internen Reflexionen an diesen Lunkern können das Lichtleitverhalten der Wandleraufnahme günstig beeinflussen. Wenn an bestimmten Stellen der Wandleraufnahme eine Lichtauskopplung völlig unterbunden werden soll, können dort auch Metallisierungen oder sonstige geeignete Beschichtungen aufgebracht werden.

Als Leuchtmittel können grundsätzlich bekannte Komponenten eingesetzt werden. Aus Platzgründen werden bevorzugt Leuchtdioden, insbesondere SMD-Leuchtdioden, verwendet.

Ein einfacher und mechanisch stabiler Aufbau wird erreicht, wenn der Leuchtmittelträger formschlüssig in der Wandleraufnahme aufgenommen ist. Zweckmäßig wird dabei der Leuchtmittelträger so dimensioniert, dass er sich im eingebauten Zustand an einer Innenwand der Wandleraufnahme oder der Gehäusehülse abstützt. Der Aufbau ist dann besonders stabil.

Die auszuleuchtende Signalleuchtfläche kann beispielsweise ein Kreisring an einer Stirnseite des Sensors sein. Bevorzugt werden die Leuchtmittel dann in einem äußeren Randbereich des Leuchtmittelträgers angeordnet. Die Ausleuchtung ist besonders homogen, wenn die Leuchtmittel gleichmäßig über den Umfang verteilt angeordnet sind.

Grundsätzlich ist die Zahl der auf einem Leuchtmittelträger unterzubringenden Leuchtmittel nur durch den zur Verfügung stehenden Platz beschränkt. Beispielsweise für zylindrische Sensoren mit einem Durchmesser von etwa 20 mm können bereits mit vier Leuchtdioden, welche auf dem Leuchtmittelträger in einem Winkelabstand von jeweils 90° angeordnet sind, sehr gute Resultate für eine kreisringartige Signalleuchtfläche erzielt werden.

Der mechanische Aufbau und der Zusammenbau können einfacher gestaltet werden, wenn der Leuchtmittelträger Ausnehmungen, insbesondere Ausfräsungen, zum Einstecken des Baugruppenträgers aufweist. In einem Verfahrensschritt kann dann der Baugruppenträger mit dem Leuchtmittelträger zusammengesteckt werden und hierdurch kann ein Elektronikmodul gebildet werden.

Eine weitere grundlegende Schwierigkeit bei Sensoren der hier beschriebenen Art besteht darin, dass beispielsweise bei einer Deckenmontage von abstandsmessenden Sensoren mit großer Reichweite, etwa Ultraschallnäherungsschalter oder optische Näherungsschalter, wegen der Einbaulage des Sensors und einer Positionierung der Sensoranzeigen an einem dem Messende gegenüberliegenden Ende des Wandlers bisher in der Regel keine Sichtbarkeit der Schaltanzeigen an einem Messende gegeben ist. Für eine Inbetriebnahme des montierten Sensors und eine Überprüfung der richtigen Funktionalität eines solchen Sensors im laufenden Betrieb ist aber eine optische Signalisierung von Betriebszuständen, von Schaltzuständen, von Programmier- oder Rückmeldeanzeigen vorteilhaft.

Oftmals ist es auch erforderlich, einen Sensor in einer Verblendung an einer Industrieanlage zu installieren. Wenn bei den Sensoren nur an dem Messende oder dem Anschlussende eine optische Signalisierung erfolgt, können die vorgenannten Betriebs- und/oder Schaltzustandsanzeigen nur jeweils von einer Seite eingesehen werden. Häufig ist dies die Seite, die dem Wandlerelement abgewandt ist.

Darüber hinaus ist die Einbaulage von Näherungsschaltern, unabhängig vom jeweils eingesetzten Sensor-Prinzip, in der Industrie im Allgemeinen nicht von vornherein bestimmbar. Jedoch ist es zur Inbetriebnahme von Anlagen mit Näherungsschaltern vorteilhaft und oft erforderlich, die Anzeigeelemente, also die optische Signalisierung, des Sensors einsehen zu können. Es ist demgemäß von Vorteil, unabhängig von einer Einbaulage baulage des Sensors immer an wenigstens einem Ende eines Näherungsschalters eine Anzeige der vorgenannten Zustände zu haben.

Bei dem erfindungsgemäßen Näherungsschalter sind an dem Anschlussende weitere Leuchtmittel vorhanden zum optischen Signalisieren von Betriebs- und/oder Schaltzuständen des Näherungsschalters nach außen. Vorteilhaft sind dabei die Leuchtmittel am Anschlussende auf einem weiteren Leuchtmittelträger angeordnet, der relativ zum Baugruppenträger ebenfalls querstehend positioniert ist. Grundsätzlich können sowohl an dem Messende als auch an dem Anschlussende Leuchtmittel auf dem Baugruppenträger angeordnet werden.

Hierdurch können für die anschlussseitigen Leuchtmittel dieselben positiven Eigenschaften im Hinblick auf die Rundumsichtbarkeit erreicht werden, wie für das Messende.

Insbesondere für eine Decken- und Paneel-Montage wird demgemäß sowohl eine Rundumsichtbarkeit von vorn als auch eine Rundumsichtbarkeit von hinten erreicht. Ausgenommen sind hiervon lediglich Bereiche der Halterung. Diese vollständige Rundumsichtbarkeit wird insbesondere für zylindrische Näherungsschalter erzielt.

Bei der Ausführungsvariante, bei der sowohl am Messende als auch am Anschlussende Leuchtmittel vorhanden sind, ergibt sich ein erheblicher praktischer Nutzen. Schaltzustände, Betriebszustände und Funktionsanzeigen von Sensoren können auch dann abgelesen werden, wenn diese an unzugänglichen Stellen, beispielsweise in großen Fabrikhallen an der Decke, montiert sind. Weiterhin können die entsprechenden Anzeigen auch bei Sensoren abgelesen und erkannt werden, die in einer Maschinenverblendung, beispielsweise in einer Metallwand, montiert sind.

Zudem spricht das Umleuchten, insbesondere von runden Bedienelementen, beispielsweise in der Konsumindustrie, vom Design die Kunden an. Dies ist auch bei Näherungsschaltern der Fall. Neben einem praktischen Nutzen wird durch die erfindungsgemäßen technischen Maßnahmen auch ein ansprechendes Design ermöglicht.

Im Stand der Technik war es bisher schwierig, die zumeist sehr dünne Umrandung des Wandlerelements oder der Wandleraufnahmen durchgängig, also homogen, auszuleuchten, da die Leuchtmittel sehr klein, also Platz sparend, dabei leuchtstark und außerdem preisgünstig sein müssen. Vorzugsweise werden SMD-Leuchtdioden eingesetzt. Mit Hilfe der vorliegenden Erfindung wird die homogene Ausleuchtung der jeweiligen Signalleuchtfläche deutlich verbessert.

Bei einer weiteren vorteilhaften Variante ist die Wandleraufnahme an einem Messende geschlossen. Dies ist insbesondere dann zweckmäßig, wenn der Sensor in einer Umgebung mit hohem Verschmutzungs- oder Feuchtigkeitseintrag verwendet werden soll.

In diesem Zusammenhang kann außerdem von Vorteil sein, wenn die Wandleraufnahme vom Messende bis zum Anschlussende durch die Gehäusehülse durchreicht und sich am Anschlussende mit einem Anschlussstück in einem dichtungsmäßigen Eingriff befindet. Man benötigt so nur einen einzigen dichtenden Übergang. Das Anschlussstück kann beispielsweise Teil eines Steckverbinders sein.

Weitere Vorteile und Merkmale der Erfindung werden nachstehend mit Bezug auf die beigefügten Figuren beschrieben. Hierin zeigt:
- Fig. 1: in einer Explosionsdarstellung ein erstes Ausführungsbeispiel eines erfindungsgemäßen Sensors;
- Fig. 2: in einer Explosionsdarstellung ein zweites Ausführungsbeispiel eines erfindungsgemäßen Sensors;
- Figuren 3 bis 5: weitere Details der in den Figuren 1 und 2 dargestellten Ausführungsbeispiele;
- Fig. 6: einen Schirmbecher in einer perspektivischen Ansicht;
- Figuren 7 und 8: eine Wandleraufnahme in perspektivischen Ansichten; und
- Figuren 9 bis 11: Montagemöglichkeiten eines erfindungsgemäßen Sensors.

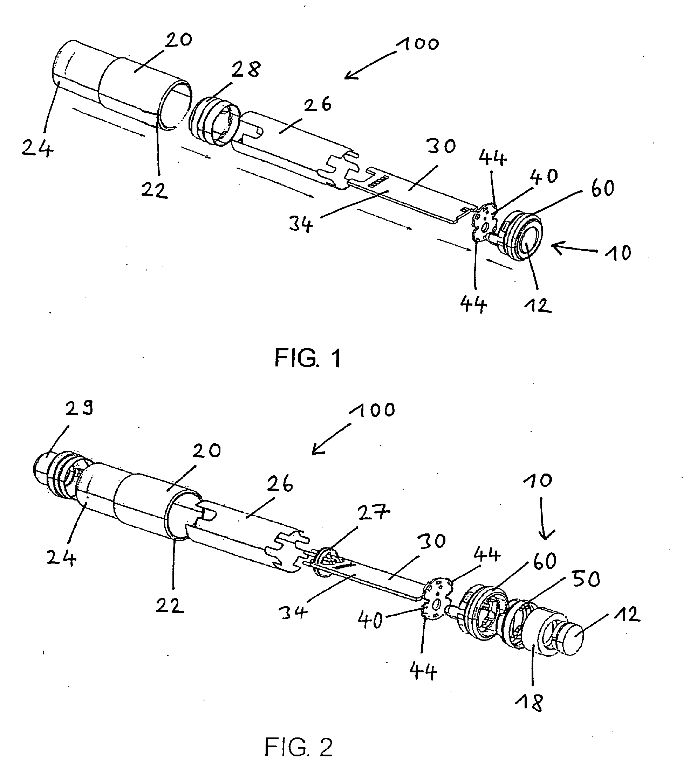

Zwei Ausführungsbeispiele eines erfindungsgemäßen Sensors 100 sind in den Figuren 1 und 2 dargestellt. Es handelt sich jeweils um zylindrische Ultraschallsensoren, die sich in ihrem Aufbau nur im Bereich eines Anschlussendes 24 unterscheiden. Bei dem in Fig. 1 gezeigten Beispiel ist ein Kabelabgang vorgesehen. Das in Fig. 2 gezeigte Beispiel weist einen Steckerabgang auf.

Als wesentliche Komponenten umfassen die Sensoren 100 jeweils eine Wandlereinheit 10, eine Gehäusehülse 20, einen Baugruppenträger 30 und einen im Wesentlichen kreisscheibenförmigen Leuchtmittelträger 40. Die Wandlereinheit 10 beinhaltet ein Wandlerelement 12, im gezeigten Beispiel einen Ultraschallwandler, eine Ausschäumung 18, einen Schirmbecher 50 und eine Wandleraufnahme 60.

Auf dem Baugruppenträger 30, bei dem es sich um eine Platine handelt, ist eine nicht im Einzelnen gezeigte Sensorelektronik 34 untergebracht. Bei dem Leuchtmittelträger 40, auf dem jeweils vier SMD-Leuchtdioden 44 als Leuchtmittel angeordnet sind, handelt es sich ebenfalls um eine Platine. Der Leuchtmittelträger 40 ist im eingebauten Zustand senkrecht zum Baugruppenträger 30 angeordnet und in der Wandleraufnahme 60 zumindest teilweise formschlüssig aufgenommen.

Eine Schirmhülse 26 dient zum Abschirmen von elektromagnetischen Störungen von der Sensorelektronik 34. Die Wandlereinheit 10 ist im eingebauten Zustand in der Gehäusehülse 20 im Bereich eines Messendes 22 aufgenommen. An dem dem Messende 22 gegenüberliegenden Anschlussende 24 der Gehäusehülse 20 befinden sich im zusammengebauten Zustand Anschlussmittel. Bei dem in Fig. 1 gezeigten Ausführungsbeispiel handelt es sich dabei um einen nicht näher dargestellten Kabelabgang. Eine Anschlusshülse 28 dient dabei zum stabilen Positionieren des Baugruppenträgers 30 im Bereich des Anschlussendes 24 der Gehäusehülse 20.

Bei der in Fig. 2 gezeigten Variante ist ein Steckerabgang vorgesehen, der im Wesentlichen durch ein mit dem Baugruppenträger 30 verbundenes Steckermodul 27 und eine Anschlusshülse 29 gebildet wird.

Die Wandleraufnahme 60 und die Anschlusshülsen 28, 29 sind jeweils mindestens teilweise transparent oder semitransparent gebildet, so dass mit den in den Figuren 1 und 2 gezeigten Varianten eine optische Signalisierung von Betriebs- und/oder Schaltzuständen des Sensors 100 sowohl in Richtung des Messendes 22 als auch in Richtung des Anschlussendes 24 möglich ist. Die Erfindung bezieht sich insbesondere auf die illuminierte oder beleuchtete Wandlereinheit 10.

Entscheidend ist, dass neben dem transparenten oder semitransparenten und beleuchteten oder illuminierten Endabschluss im Bereich des Anschlussendes 24 des Sensors 100 nun auch eine mindestens semitransparente und illuminierbare Wandlereinheit 10 verwendet werden kann. Durch die Kombination der beiden illuminierbaren Sensorabschlüsse im Bereich des Messendes 24 und im Bereich des Anschlussendes 24 kann eine weitgehend vollständige Rundumsichtbarkeit von Betriebszuständen, Schaltzuständen und/oder von anderen Anzeigen erfolgen, die für Näherungsschalter von Bedeutung sind. Die Sensoren 100 sind insgesamt modular aufgebaut. Die Wandlereinheit 10, der Baugruppenträger 30 und der Leuchtmittelträger 40 sind so zusammengefügt, dass die Schirmhülse 26, die Anschlusshülse 28, 29 und die Gehäusehülse 20, welche grundsätzlich eine beliebige Länge aufweisen kann, durch einfaches Zusammenschieben im Produktionsprozess zusammengefügt werden können.

Bei den in den Figuren 1 und 2 gezeigten Sensoren werden demgemäß Leuchtdioden zur Schaltanzeige sowohl front- als auch endseitig eingesetzt. Besonders vorteilhaft ist hierbei die Beleuchtung auch im Bereich der Wandlereinheit 10. Weiterhin kann eine Minderung der Einkopplung bei Stromeinspeisung, also ein insgesamt verbessertes Stromeinspeisungsverhalten, erreicht werden. Für die Wandleraufnahme 60 ergibt sich eine vereinfachte Montage aufgrund eines modularen Konzepts. Der Baugruppenträger 30 wird durch die Wandleraufnahme 60 geführt. Reduzierte Baulängen der Wandleraufnahme 60 können durch direktes Kontaktieren der Wandleraufnahme 60 erreicht werden.

Für die optische Signalisierung können beispielsweise gelbe, grüne und rote Leuchtdioden verwendet werden. Beispielsweise kann eine Schaltanzeige mit einer gelben Leuchtdiode, das Vorliegen einer Versorgungsspannung mit einer grünen Leuchtdiode und ein Fehler mit einer roten Leuchtdiode signalisiert werden.

Bei der in Fig. 2 gezeigten Variante wird die transparente Anschlusshülse 29, die auch als Endkappe bezeichnet werden kann, erst zum Schluss montiert, während bei dem in Fig. 1 gezeigten Beispiel zum Schluss die Gehäusehülse 20 übergezogen wird. Bei Fig. 1 handelt es sich demgemäß um ein einzügiges Verfahren. Generell sind aber beide Montagearten auf beide Varianten anwendbar.

Da die Sensoren generell modular aufgebaut sind, kann man die in Figuren 1 und 2 dargestellten Varianten auch mit einer gewinkelten Wandlereinheit ausführen.

Die Wandleraufnahme 60 kann grundsätzlich durch Umspritzen des Schirmbechers 50 hergestellt werden. Alternativ kann der Schirmbecher 50 auch einfach in die Wandleraufnahme 60 eingesteckt werden.

Eine Hauptaufgabenstellung bei einer beliebig gearteten Wandlereinheit liegt darin, gerade bei miniaturisierten Sensoren, beispielsweise mit einem Durchmesser von 18 mm, 12 mm oder kleiner, die Wandlereinheit mit Leuchtmitteln zugänglich zu machen, auch wenn es sich bei den Leuchtmitteln um SMD-Leuchtdioden handelt.

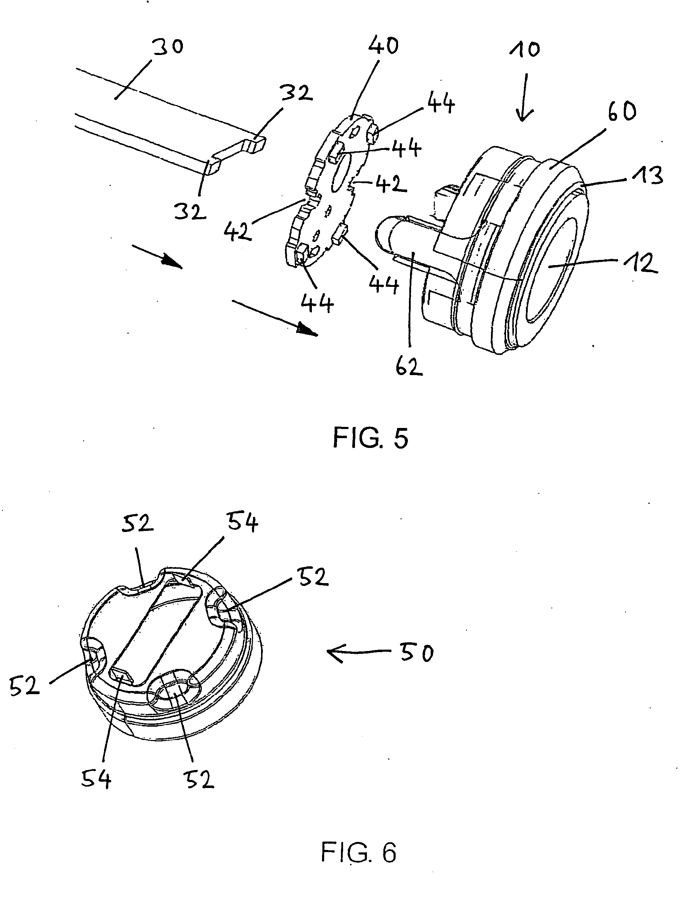

Der Schirmbecher 50 ist, wie aus Fig. 6 ersichtlich, mit insgesamt vier symmetrisch angeordneten Ausbuchtungen 52 versehen, in die im eingebauten Zustand jeweils eine Leuchtdiode eingreift. Die Leiterplatte, welche den Leuchtmittelträger 40 bildet, wird über eine Lötverbindung mit dem Schirmbecher 50 elektrisch leitend und insoweit auch mechanisch verbunden und bildet den Abschluss der Montage der Wandlereinheit 10. Zum Verlöten des Leuchtmittelträgers 40 mit dem Schirmbecher 50 sind am Schirmbecher 50 Verbindungslaschen 54 gebildet.

Die Erfindung ist anwendbar auf gerade und gewinkelte illuminierte Wandlereinheiten, insbesondere für induktive, kapazitive und sonstige elektromagnetischen Sensoren.

Bei induktiven Sensoren, bei denen als Wandlerelement eine Spule im Bereich einer Stirnseite der Gehäusehülse angeordnet ist, kann eine Schwierigkeit darin bestehen, dass das Spulensystem nahezu den kompletten Frontbereich der Wandlerfläche einnimmt. Auch bei solchen Näherungsschaltern kann mit der vorliegenden Erfindung eine verbesserte Ausleuchtung, beispielsweise einer kreisringförmigen Signalleuchtfläche, erzielt werden.

Eine weitere Lösung kann darin bestehen, dass eine Leiterplatte durch einen Fortsatz in das Zentrum des Spulensystems eingreift und die Leuchtmittel zur transparenten Wandleraufnahme in den vorderen Bereich des Sensors bringt. Dies eignet sich vor allem für Sensoren mit Wandleraufnahmen, die am Ende der Gehäusehülse abgeschlossen sind. Im Zentrum der transparent oder semitransparent ausgeführten Wandleraufnahme können ebenfalls Fortsätze, beispielsweise mit einer Vergussmasse, angeformt werden, durch welche die Lichtleitung begünstigt wird. Ergänzend oder alternativ können auch gezielt Lunker eingeschlossen werden.

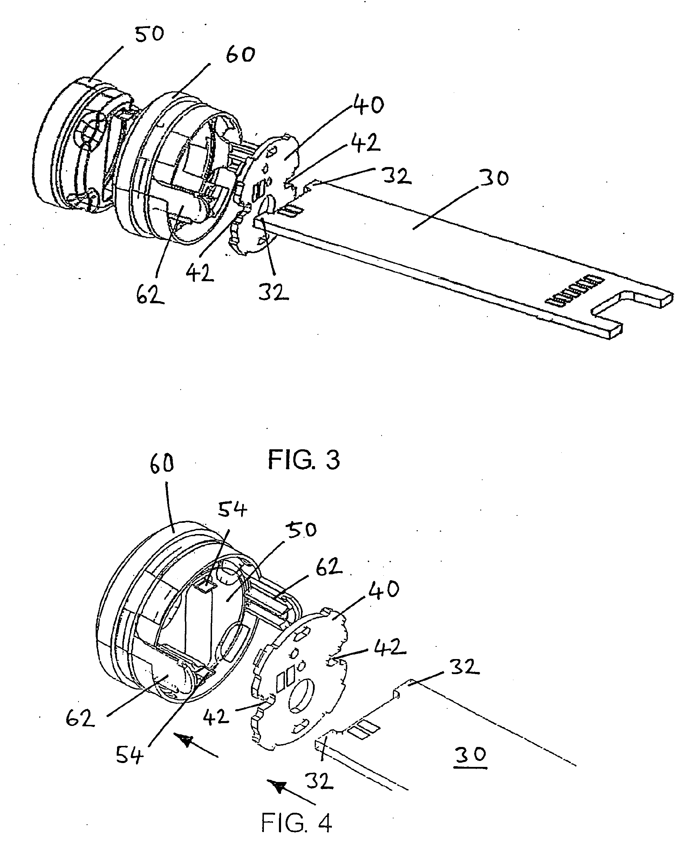

Weitere Details des erfindungsgemäßen Sensors und des erfindungsgemäßen Verfahrens werden mit Bezug auf die Figuren 3 bis 8 erläutert, die sich jeweils sowohl auf das Ausführungsbeispiel nach Fig. 1 wie auch auf die in Fig. 2 gezeigte Variante beziehen. Äquivalente Komponenten sind in allen Figuren jeweils mit denselben Bezugzeichen versehen.

Zum einfachen Verbinden des Baugruppenträgers 30 mit dem querstehend angeordneten Leuchtmittelträger 40 sind in dem Leuchtmittelträger 40 schlitzartige Ausfräsungen 42 gebildet, in welche der Baugruppenträger 30 mit Zungen 32 aufgenommen werden kann. Wie aus Fig. 3 ersichtlich, wird der Schirmbecher von vorn in die Wandleraufnahme 60 eingesetzt. Grundsätzlich kann die Wandleraufnahme 60 auch um den Schirmbecher 50 herum angespritzt werden. Sodann wird der Leuchtmittelträger 40, insbesondere ein bereits mit dem Baugruppenträger 30 verbundener Leuchtmittelträger 40, in die Wandleraufnahme 50 eingesetzt. Dies ist aus den Figuren 4 und 5 ersichtlich.

Wie beispielsweise aus Fig. 5 ersichtlich, sind auf den Leuchtmittelträger 40 insgesamt vier Leuchtdioden 44 als Leuchtmittel an einem äußeren Umfang des Leuchtmittelträgers 40 angeordnet.

Der Leuchtmittelträger 40 mit den Leuchtdioden 44 wird zum Abschluss der Montage der Wandlereinheit 10 auf den Schirmbecher 50 mit Hilfe der Verbindungslaschen 54 gelötet. Nach dem Auflöten des Leuchtmittelträgers 40 kann der Baugruppenträger einfach in Führungsansätze 62, welche an der Wandleraufnahme 60 gebildet sind, eingeschoben werden und mit dem Leuchtmittelträger 40 elektrisch und mechanisch verbunden werden. Diese Verfahrensschritte sind insbesondere aus den Figuren 4 und 5 ersichtlich, in denen die Fertigstellung sowie die Teilmontage des Baugruppenträgers 30 gezeigt ist. Insgesamt wird so eine illuminierbare Wandlereinheit 10 ermöglicht.

Die illuminierbare Wandlereinheit 10, welche einen Kern der Erdindung bildet, dient dazu, beispielsweise eine Ultraschallwandlereinheit, bestehend aus einer Auskoppelschicht, einem Piezoelement, einem Schirmbecher und einer Ausschäumung, aufzunehmen. Weiterhin wird über wenigstens zwei Lichteinkoppelelemente 64 das Licht der Leuchtdioden 44 auf dem Leuchtmittelträger 40 durch die transparent oder semitransparent ausgeführte Wandleraufnahme 60 zu einem vorderen Lichtauskoppelring 13, also einer Signalleuchtfläche, geleitet, der in einem zusammengebauten Zustand nur von außen sichtbar ist. Dies ist beispielsweise in Fig. 5 dargestellt.

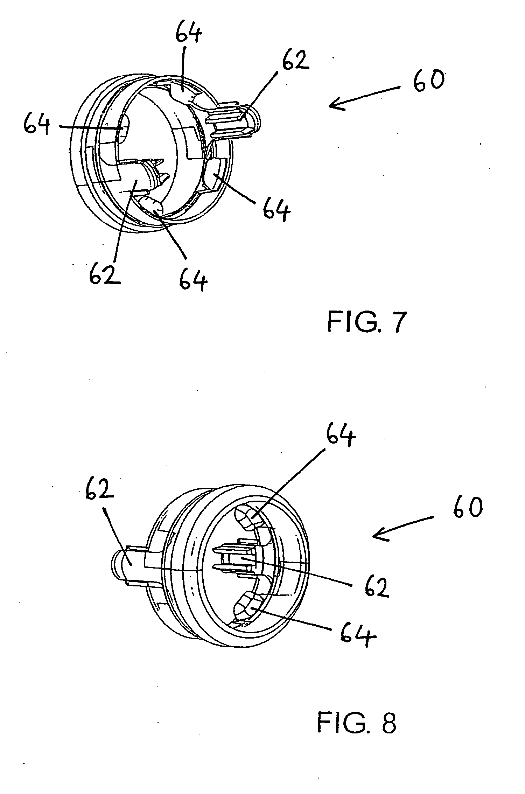

Weiterhin sind in Fig. 5 am Ende der Wandleraufnahme 60 die Führungsansätze 62 zur Führung des Baugruppenträgers 30 zu sehen, welche dazu dienen, den Baugruppenträger 30 zu zentrieren und zu fixieren. Eine Lichteinkopplung kann gegebenenfalls auch über die Führungsansätze 62 erfolgen. Hierzu können beispielsweise auch auf dem Baugruppenträger 30 an geeigneten Positionen Leuchtmittel angeordnet werden. Die Lichteinkoppelelemente 64 und die Führungsansätze 62 der Wandleraufnahme 60 sind außerdem in den Figuren 7 und 8 gezeigt.

Fig. 4 zeigt außerdem, wie der Leuchtmittelträger 40 auf die Laschen 54 des Schirmbechers 50 in einem vorletzten Produktionsschritt gelötet wird. Danach wird der komplette Ultraschallwandler in der Wandleraufnahme 60 verschäumt.

Fig. 6 zeigt den Schirmbecher 50 mit Ausbuchtungen 52 für die Leuchtmittel. Eine Einkopplung von elektromagnetischen Störungen wird weitestgehend verhindert über die Schirmhülse 26 und den Schirmbecher 50.

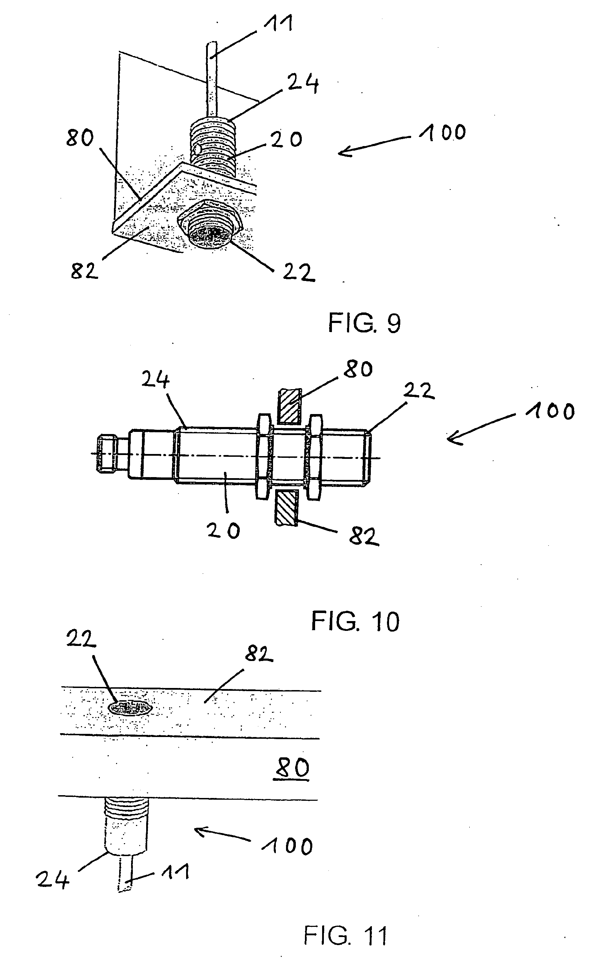

In den Figuren 9 bis 11 sind Einsatzmöglichkeiten für den erfindungsgemäßen Sensor 100 schematisch dargestellt. Figuren 9 und 10 zeigen eine Deckenmontage von abstandsmessenden Sensoren. Dargestellt ist ein erfindungsgemäßer Sensor 100, der an einer Deckenplatte 80 montiert ist. Von einer Sichtseite 82 der Platte 80 kann die hier nicht in weiteren Details dargestellte illuminierbare Wandlereinheit eingesehen werden. Darüber hinaus kann von einer rückwärtigen Sensorseite auch eine Signalisierung im Bereich des Anschlussendes 24 für eine Schaltzustandsanzeige von einem Benutzer wahrgenommen werden. Eine geringfügige Beschränkung der Rundumsichtbarkeit auf der rückwärtigen Seite ergibt sich dabei nur durch ein Anschlusskabel 11.

Fig. 11 zeigt ein Beispiel, bei dem ein erfindungsgemäßer Sensor 100 mit einem Messende 22 bündig mit einer Sichtseite 82 der Platte 80 abschließt. Auch hier sind sowohl am Messende 22 als auch am Anschlussende 24 optische Signalisierungen verwirklicht, so dass insgesamt eine hervorragende Rundumsichtbarkeit erzielt wird, die nur geringfügig durch ein Anschlusskabel 11 und durch die Platte 80 beeinträchtigt wird.

Mit der vorliegenden Erfindung wird ein neuartiger Sensor, insbesondere für die Automatisierungstechnik, bereitgestellt, bei dem mit einfachen Mitteln eine sehr weitgehende Rundumsichtbarkeit einer Anzeige von Betriebszuständen, Schaltzuständen, Programmieranzeigen und/oder Rückmeldeanzeigen erreicht werden kann. Besonders vorteilhaft kann die Erfindung bei zylindrischen Näherungsschaltern eingesetzt werden. Der jeweilige Wandler kann als Empfänger und/oder als Sender dienen. Es kann sich um einen geraden Wandler handeln, der auf einer Leiterplatte angeordnet oder in einem zylindrischen Gehäuse untergebracht ist. Außerdem kann der Wandler auch in einem quaderförmigen Gehäuse untergebracht sein, oder es kann ein gewinkelter Wandler auf einer Leiterplatte verwendet werden. Diese Anordnungsmöglichkeiten können, je nach Anwendungszweck, grundsätzlich beliebig miteinander kombiniert werden. Das erfindungsgemäße Konzept kann grundsätzlich auch für Sensoren mit quaderförmigen Bauformen angewendet werden.

Ein wesentlicher Vorteil der vorliegenden Erfindung ist darin zu sehen, dass eine Signalisierung der gewünschten Zustände und Anzeigen sowohl an einem Messende als auch an einem Anschlussende erfolgen kann. Hierdurch wird eine Inbetriebnahme sowie eine Kontrolle einer einwandfreien Funktion eines bereits eingebauten Sensors deutlich vereinfacht. Dies ist ein besonders wichtiger Vorteil, da eine schnelle Fehlerdiagnose ermöglicht wird, beispielsweise ob ein Sensor oder ein Schalter mit einer Betriebsspannung versorgt wird, ob gewisse Plausibilitätstests die richtigen Ergebnisse liefern, beispielsweise Schaltausgänge geschaltet werden und/oder ob der Sensor sich in einem Programmiermodus oder in einem normalen Betriebsmodus befindet.

Weitgehend unabhängig von einer Einbaulage der Sensoren können demgemäß die gewünschten Signalisierungen vom Betriebspersonal eingesehen werden.

## Patentansprüche

1. Näherungsschalter
mit einer Gehäusehülse (20),
mit einer Wandlereinheit (10), die in der Gehäusehülse (20) an einem Messende (22) angeordnet ist,
mit Anschlussmitteln an einem dem Messende (22) gegenüberliegenden Anschlussende (24) der Gehäusehülse (20) und
mit einem in der Gehäusehülse (20) aufgenommenen Baugruppenträger (30), auf dem eine Sensorelektronik (34) angeordnet ist und der sich entlang einer Achse der Gehäusehülse (30) erstreckt,
**dadurch gekennzeichnet,**
**dass** zum optischen Signalisieren von Betriebs- und/oder Schaltzuständen des Näherungsschalters (100) nach außen sowohl an dem Messende (22) als auch am Anschlussende (24) Leuchtmittel vorhanden sind,
**dass** im Bereich der Wandlereinheit (10) eine Mehrzahl von Leuchtmittel (44) auf einem separaten plattenartigen Leuchtmittelträger (49) angeordnet sind und dass der plattenartige Leuchtmittelträger (40) im Bereich der Wandlereinheit (10) querstehend zum Baugruppenträger (30) angeordnet ist.

2. Näherungsschalter nach Anspruch 1,
**dadurch gekennzeichnet,**
**dass** die Wandleraufnahme (60) wenigstens teilweise aus einem transparenten Kunststoff gebildet ist.

3. Näherungsschalter nach Anspruch 1 oder 2,
**dadurch gekennzeichnet,**
**dass** an der Wandleraufnahme (60) für jedes Leuchtmittel (44) Lichteinkoppelelemente (64) angeformt sind.

4. Näherungsschalter nach einem der Ansprüche 2 oder 3,
**dadurch gekennzeichnet,**
**dass** die Wandleraufnahme (60) in Teilbereichen zum Leiten des Lichts der Leuchtmittel (44) metallisiert ist.

5. Näherungsschalter nach einem der Ansprüche 1 bis 4,
**dadurch gekennzeichnet,**
**dass** der Leuchtmittelträger (40) formschlüssig in der Wandleraufnahme (60) aufgenommen ist.

6. Näherungsschalter nach einem der Ansprüche 1 bis 5,
**dadurch gekennzeichnet,**
**dass** der Leuchtmittelträger (40) sich im eingebauten Zustand an einer Innenwand der Wandleraufnahme (60) oder der Gehäusehülse (20) abstützt.

7. Näherungsschalter nach einem der Ansprüche 1 bis 6,
**dadurch gekennzeichnet,**
**dass** der Leuchtmittelträger (40) Ausnehmungen, insbesondere Ausfräsungen (42), zum Einstecken des Baugruppenträgers (30) aufweist.

8. Näherungsschalter nach einem der Ansprüche 1 bis 7,
**dadurch gekennzeichnet,**
**dass** die Leuchtmittel am Anschlussende (24) auf einen weiteren Leuchtmittelträger angeordnet sind, der relativ zum Baugruppenträger (30) querstehend positioniert ist.

9. Näherungsschalter nach einem der Ansprüche 1 bis 8,
**dadurch gekennzeichnet,**
**dass** die Leuchtmittel (44) Leuchtdioden (44) sind.

10. Näherungsschalter nach einem der Ansprüche 1 bis 9,
**dadurch gekennzeichnet,**
**dass** die Leuchtmittel (44) in einem äußeren Randbereich des Leuchtmittelträgers (40) oder der Leuchtmittelträger angeordnet sind.

11. Näherungsschalter nach Anspruch 10,
**dadurch gekennzeichnet,**
**dass** die Leuchtmittel (44) gleichmäßig über den Umfang des Leuchtmittelträgers (40) oder der Leuchtmittelträger verteilt angeordnet sind.

12. Näherungsschalter nach einem der Ansprüche 1 bis 11,
**dadurch gekennzeichnet,**
**dass** mindestens vier Leuchtmittel (44) auf einem Leuchtmittelträger (40) vorhanden sind.

13. Näherungsschalter nach einem der Ansprüche 1 bis 12,
**dadurch gekennzeichnet,**
**dass** die Wandleraufnahme (60) an dem Messende (22) geschlossen ist.

14. Näherungsschalter nach einem der Ansprüche 1 bis 13,
**dadurch gekennzeichnet,**
**dass** die Wandleraufnahme (60) vom Messende (22) bis zum Anschlussende (24) durch die Gehäusehülse (20) durchreicht und sich am Anschlussende (24) mit einem Anschlussstück in einem dichtungsmäßigen Eingriff befindet.

15. Verfahren zur Herstellung eines Näherungsschalters nach einem der Ansprüche 1 bis 14,
bei dem ein Schirmbecher (50) mit einer Wandleraufnahme (60) verbunden wird, bei dem ein Wandlerelement (12) in den Schirmbecher (50) eingesetzt wird, wobei der Schirmbecher (50), die Wandleraufnahme (60) und das Wandlerelement (12) eine Wandlereinheit (10) bilden,
bei dem ein plattenartiger Leuchtmittelträger (40), auf dem eine Mehrzahl von Leuchtmitteln (44) angeordnet ist, mit der Wandlereinheit (10) verbunden wird, bei dem ein Baugruppenträger (30) mit einer Sensorelektronik (34) an einem Messende mit der Wandlereinheit (10) verbunden wird,
wobei der Leuchtmittelträger (40) relativ zum Baugruppenträger (30) im zusammengebauten Zustand querstehend angeordnet ist,
bei dem der Baugruppenträger (30) mit der Wandlereinheit (10) in eine Gehäusehülse (20) eingesetzt wird,
wobei im zusammengebauten Zustand eine Achse der Gehäusehülse (20) quer zum Leuchtmittelträger (40) verläuft,
und bei dem weitere Leuchtmittel zum Signalisieren von Betriebs- und/oder Schaltzuständen des Näherungsschalters (100) nach außen auf einem weiteren Leuchtmittelträger angeordnet werden und bei dem der weitere Leuchtmittelträger relativ zum Baugruppenträger (30) querstehend positioniert wird.

## Claims

1. Proximity switch
having a housing sleeve (20),
having a transducer unit (10) placed in a housing sleeve (20) at a measurement end (22),
with connection means at a connection end (24) of the housing sleeve (20) opposite to the measurement end (22),
with a module carrier (30) received in the housing sleeve (20) and on which is placed a sensor electronics (34) and which extends along an axis of the housing sleeve (30),
**characterized in that**
illuminants (44) are provided both at the measurement end (22) and at the connection end (24) for the optical signalling to the outside of operating and/or switching states of the proximity switch (100),
that a plurality of illuminants (44) are placed on a separate plate-like illuminant carrier (49) in the vicinity of the transducer unit (10) and that the plate-like illuminant carrier (40) is positioned transversely to the module carrier (30) in the vicinity of the transducer unit (10).

2. Proximity switch according to claim 1,
**characterized in that**
the transducer receptacle (60) is at least partly formed from a transparent plastic.

3. Proximity switch according to claim 1 or 2,
**characterized in that**
light coupling in elements (64) are shaped onto the transducer receptacle (60) for each illuminant (44).

4. Proximity switch according to one of the claims 2 or 3,
**characterized in that**
the transducer receptacle (60) is metallized in partial areas for conducting the light of the illuminants (44).

5. Proximity switch according to one of the claims 1 to 4,
**characterized in that**
the illuminant carrier (40) is positively received in the transducer receptacle (60).

6. Proximity switch according to one of the claims 1 to 5,
**characterized in that**,
in the installed state, the illuminant carrier (40) is supported on an inner wall of transducer receptacle (60) or the housing sleeve (20).

7. Proximity switch according to one of the claims 1 to 6,
**characterized in that**
the illuminant carrier (40) has recesses, particularly milled slots (42) for the plugging in of the module carrier (30).

8. Proximity switch according to one of the claims 1 to 7,
**characterized in that**
the illuminants at the connection end (24) are placed on a further illuminant carrier, which is positioned transversely relative to the module carrier (30).

9. Proximity switch according to one of the claims 1 to 8,
**characterized in that**
the illuminants (44) are light emitting diodes (44).

10. Proximity switch according to one of the claims 1 to 9,
**characterized in that**
the illuminants (44) are positioned in an outer marginal area of the illuminant carrier (40) or the illuminant carriers.

11. Proximity switch according to claim 10,
**characterized in that**
the illuminants (44) are uniformly distributed over the circumference of the illuminant carrier (40) or the illuminant carriers.

12. Proximity switch according to one of the claims 1 to 11,
**characterized in that**
there are at least four illuminants (44) on an illuminant carrier (40).

13. Proximity switch according to one of the claims 1 to 12,
**characterized in that**
the transducer receptacle (60) is closed at the measurement end (22).

14. Proximity switch according to one of the claims 1 to 13,
**characterized in that**
the transducer receptacle (60) extends through the housing sleeve (20) from the measurement end (22) to the connection end (24) and at the connection end (24) is in a sealing engagement with a connecting piece.

15. Method for the manufacture of a proximity switch according to one of the claims 1 to 14,
in which a shielding can (50) is connected to a transducer receptacle (60),
in which a transducer element (12) is inserted in the shielding can (50),
in which the shielding can (50), the transducer receptacle (60) and the transducer element (12) form a transducer unit (10),
in which a plate-like illuminant carrier (40) on which is located a plurality of illuminants (44) is connected to the transducer unit (10),
in which a module carrier (30) with a sensor electronics (34) is connected to the transducer unit (10) at a measurement end,
in which the illuminant carrier (40) is positioned transversely relative to the module carrier (30) in the assembled state,
in which the module carrier (30) with the transducer unit (10) is inserted in a housing sleeve (20), and
in which in the assembled state an axis of the housing sleeve (20) runs transversely to the illuminant carrier (40)
and in which further illuminants are placed on a further illuminants carrier for the optical signalling to the outside of operating and/or switching states of the proximity switch (100) and in which the further illuminants carrier is positioned transversely relative to the module carrier (30).

## Revendications

1. Capteur de proximité
avec une douille de boîtier (20),
avec une unité de convertisseur (10) qui est placée dans la douille de boîtier (20) au niveau d'une extrémité de mesure (22),
avec des moyens de raccordement au niveau d'une extrémité de raccordement (24) de la douille de boîtier (20) opposée à l'extrémité de mesure (22), et
avec un support de sous-ensemble (30) placé dans la douille de boîtier (20), sur lequel est placée une électronique de capteur (34) et qui s'étend le long d'un axe de la douille de boîtier (30),
**caractérisé en ce que**, pour la signalisation visuelle d'états de service et/ou de commutation du capteur de proximité (100) vers l'extérieur, des moyens lumineux sont présents aussi bien sur l'extrémité de mesure (22) que sur l'extrémité de raccordement (24),
**en ce qu'**au niveau de l'unité de convertisseur (10), une pluralité de moyens lumineux (44) est placée sur un support de moyens lumineux (49) séparé de type plaque et **en ce que** le support (40) de moyens lumineux de type plaque est placé au niveau de l'unité de convertisseur (10) transversalement au support de sous-ensemble (30).

2. Capteur de proximité selon la revendication 1, **caractérisé en ce que** le logement de convertisseur (60) est formé au moins en partie par une matière plastique transparente.

3. Capteur de proximité selon la revendication 1 ou 2, **caractérisé en ce que** des éléments de couplage optique (64) sont formés pour chaque moyen lumineux (44) sur le logement de convertisseur (60).

4. Capteur de proximité selon l'une des revendications 2 ou 3, **caractérisé en ce que** le logement de capteur (60) est métallisé dans certaines parties afin de diriger la lumière des moyens lumineux (44).

5. Capteur de proximité selon l'une des revendications 1 à 4, **caractérisé en ce que** le support de moyens lumineux (40) est logé par engagement positif dans le logement de convertisseur (60).

6. Capteur de proximité selon l'une des revendications 1 à 5, **caractérisé en ce que** le support de moyens lumineux (40) s'appuie à l'état monté contre une paroi intérieure du logement de convertisseur (60) ou de la douille de boîtier (20).

7. Capteur de proximité selon l'une des revendications 1 à 6, **caractérisé en ce que** le support de moyens lumineux (40) présente des évidements, en particulier des fraisages (42), pour enficher le support de sous-ensemble (30).

8. Capteur de proximité selon l'une des revendications 1 à 7, **caractérisé en ce que** les moyens lumineux de l'extrémité de raccordement (24) sont placés sur un autre support de moyens lumineux qui est positionné transversalement au support de sous-ensemble (30).

9. Capteur de proximité selon l'une des revendications 1 à 8, **caractérisé en ce que** les moyens lumineux (44) sont des diodes électroluminescentes (44).

10. Capteur de proximité selon l'une des revendications 1 à 9, **caractérisé en ce que** les moyens lumineux (44) sont placés dans une zone de bord extérieure du support de moyens lumineux (40) ou du support de moyens lumineux.

11. Capteur de proximité selon la revendication 10, **caractérisé en ce que** les moyens lumineux (44) sont répartis uniformément sur la circonférence du support de moyens lumineux (40) ou des supports de moyens lumineux.

12. Capteur de proximité selon l'une des revendications 1 à 11, **caractérisé en ce qu'**au moins quatre moyens lumineux (44) sont présents sur un support de moyens lumineux (40).

13. Capteur de proximité selon l'une des revendications 1 à 12, **caractérisé en ce que** le logement de convertisseur (60) est fermé à l'extrémité de mesure.

14. Capteur de proximité selon l'une des revendications 1 à 13, **caractérisé en ce que** le logement de convertisseur (60) traverse la douille de boîtier (20) de l'extrémité de mesure (22) jusqu'à l'extrémité de raccordement (24) et se trouve en prise hermétique avec un organe de raccordement au niveau de l'extrémité de raccordement (24).

15. Procédé de fabrication d'un capteur de proximité selon l'une des revendications 1 à 14,
dans lequel un pot écran (50) est relié à un logement de convertisseur (60),
dans lequel un élément de convertisseur (12) est inséré dans le pot écran (50),
le pot écran (50), le logement de convertisseur (60) et l'élément convertisseur (12) formant une unité de convertisseur (10),
dans lequel un support de moyens lumineux de type plaque (40), sur lequel est placée une pluralité de moyens lumineux (44) est relié à l'unité de convertisseur (10),
dans lequel un support de sous-ensemble (30) avec une électronique de capteur (34) est relié à l'unité de convertisseur (10) au niveau d'une extrémité de mesure,
dans lequel le support de moyens lumineux (40) est placé transversalement au support de sous-ensemble (30) à l'état assemblé,
dans lequel le support de sous-ensemble (30) est inséré avec l'unité de convertisseur (10) dans une douille de boîtier (20),
dans lequel, à l'état assemblé, un axe de la douille de boîtier (20) s'étend transversalement au support de moyens lumineux (40),
et dans lequel d'autres moyens lumineux sont placés sur un autre support de moyens lumineux pour signaler des états de service et/ou de commutation du capteur de proximité (100) vers l'extérieur et dans lequel l'autre support de moyens lumineux est positionné transversalement au support de sous-ensemble (30).
